# EUROPÄISCHE PATENTANMELDUNG

(11) **EP 3 709 778 A1**
(43) Veröffentlichungstag der Anmeldung: **16.09.2020**
(21) Anmeldenummer: 20151985.7
(22) Anmeldetag: 15.01.2020
(51) Int. Cl.: H05K 3/18, H05K 3/00, H05K 3/10, B33Y 10/00

(54) **KONZEPT ZUM HERSTELLEN EINES DREIDIMENSIONALEN SCHALTUNGSTRÄGERS**

(30) Priorität: 11.03.2019 DE 102019106134
(71) Anmelder: Fraunhofer-Gesellschaft zur Förderung der angewandten Forschung e.V., 80686 München (DE)
(72) Erfinder: MAGER, Thomas, 33102 Paderborn (DE); JÜRGENHAKE, Christoph, 33102 Paderborn (DE); HOPPE, Lukas, 33102 Paderborn (DE)
(74) Vertreter: 2SPL Patentanwälte PartG mbB

(57) **Zusammenfassung**

Ausführungsbeispiele befassen sich mit einem Herstellungsverfahren zum Herstellen eines dreidimensionalen Schaltungsträgers, mit einem Dreidimensionalen Schaltungsträger, mit einem Computerimplementierten Verfahren zum Generieren von Steuerungsanweisungen für einen Laser, mit einer Kunststoffmischung und mit einer Nutzung der Kunststoffmischung. Das Herstellungsverfahren umfasst ein Herstellen eines Grundkörpers des dreidimensionalen Schaltungsträgers mittels eines stereolithographischen Fertigungsverfahrens. Der Grundkörper wird aus einer Kunststoffmischung hergestellt. Die Kunststoffmischung umfasst ein Photopolymer und ein Additiv. Das Herstellen des Grundkörpers umfasst ein Bestrahlen des Grundkörpers mit Licht in einem ersten Wellenlängenbereich, um das Kunststoffgemisch zu dem Grundkörper zu härten. Das Additiv ist dazu ausgelegt, eine Laser-Strukturierung unter Bestrahlung mit einem Laser in einem zweiten Wellenlängenbereich zu ermöglichen, bei der laseraktivierbare Verbindungen in der Kunststoffmischung aktiviert werden. Der zweite Wellenlängenbereich ist von dem ersten Wellenlängenbereich verschieden. Das Herstellungsverfahren umfasst ferner Herstellen von ein oder mehreren Leiterstrukturen auf dem Grundkörper durch Laseraktivieren eines Teils einer Oberfläche des Grundkörpers mittels eines Lasers, und Metallisieren des laseraktivierten Teils der Oberfläche des Grundkörpers. Die Metallisierung bildet die ein oder mehreren Leiterstrukturen.

## Beschreibung

### Technisches Gebiet

Ausführungsbeispiele befassen sich mit einem Herstellungsverfahren zum Herstellen eines dreidimensionalen Schaltungsträgers, mit einem Dreidimensionalen Schaltungsträger, mit einem Computerimplementierten Verfahren zum Generieren von Steuerungsanweisungen für einen Laser, mit einer Kunststoffmischung und mit einer Nutzung der Kunststoffmischung.

### Hintergrund

Im Rahmen der Entwicklung und Produktion von integrierten mechatronischen Geräten steigen Anforderungen hinsichtlich Miniaturisierung, Funktionsintegration, Zuverlässigkeit und Design. Innovative Technologien sind notwendig, um diese Anforderungen zu erfüllen. In diesem Zusammenhang ist die Technologie MID (Molded Interconnect Devices, Gegossene Verbindungbauteile, auch Mechatronic Integrated Devices, Mechatronisch integrierte Geräte) sehr vielversprechend. MID ermöglicht es Entwicklern, innovative Bauteile für mechatronische Systeme zu entwerfen. Durch die Integration von mechanischen und elektronischen Funktionen auf einem einzigen Schaltungsträger können Systeme mit hoher Funktionssicherheit und -dichte sowie eine erhebliche Miniaturisierung realisiert werden. Anwendungen aus unterschiedlichen Branchen wie Kommunikation, Automobil oder Medizintechnik zeigen die Potentiale und die hohe Flexibilität im Gegensatz zu herkömmlichen Technologien (z.B. flexible Leiterplatten) auf.

Allerdings sind die Potentiale von verschiedenen Herausforderungen innerhalb der Entwicklung begleitet. Diese resultieren einerseits aus starken Abhängigkeiten zwischen der Gestalt des Produkts und seiner Herstellung; vielfältige Produktanforderungen konkurrieren mit Beschränkungen unterschiedlicher Herstellungsverfahren. Andererseits müssen enge Wechselwirkungen zwischen elektrischem / elektronischem und mechanischem Design berücksichtigt werden. Die Entwickler können diese Herausforderungen überwinden, um das Potential der Technologie MID zu erschießen.

Die MID-Technologie bietet Vorteile wie 3D-Gestaltungsfreiheit, hohe Zuverlässigkeit und geringere Herstellungskosten im Vergleich zu herkömmlichen elektronischen Baugruppen. Konventionelle MID-Produkte sind spritzgegossene thermoplastische Bauteile mit integrierten dreidimensionalen elektronischen Leiterbahnen. Die Oberfläche der verwendeten Thermoplaste kann selektiv metallisiert werden. Dies ermöglicht die Integration von elektronischen Komponenten mittels bereits bekannter Aufbau- und Verbindungstechnik. Darüber hinaus können elektrische Funktionen wie Antennen, elektromagnetische Abschirmungen oder auch thermische Funktionen wie Wärmebrücken realisiert werden. Das Design des thermoplastischen Schaltungsträgers selbst erfüllt dabei die mechanischen Funktionen des Bauteils. Montage und Anschlussfunktionen sind möglich, ebenso wie der Schutz vor Umwelteinflüssen oder Wärmemanagement.

Ein inhärenter Nachteil bei der Herstellung von MID-Bauteilen liegt in der Fertigung der Schaltungsträger. Diese werden im Spritzgussverfahren hergestellt und eignen sich daher primär für die Massenproduktion. Die hohen Investitionen in die komplexen Spritzgusswerkzeuge können sich hier bedingt durch die großen Stückzahlen schnell amortisieren. Somit steht die MID-Technologie aus wirtschaftlichen Gesichtspunkten für Kleinserien und individualisierte Produkte nicht zur Verfügung.

In Hinblick auf die Herausforderungen bei den zukunftsträchtigen Themenfeldern Industrie 4.0, IoT-Devices (Internet-of-Things-Devices, Geräte für das Internet der Dinge), RetroFit (wörtlich: Nachrüstung oder Umrüstung) etc. kann häufig das Potential, der MID-Technologie zur räumlichen Integration bietet nicht genutzt werden. Hier stehen hoch individualisierte Produkte im Fokus, die nicht in den erforderlichen hohen Stückzahlen benötigt werden.

US 2011 /0 253 435 A1 offenbart eine mehrschichtige, dreidimensionale Schaltungsstruktur, die auf einem Spritzgussverfahren oder einem druckbasierten Rapid-Prototyping-Verfahren basiert. Dabei wird ein elastisches Material verwendet, in das ein Katalysator eingemischt wird, der eine spätere Laserstrukturierung der Oberfläche ermöglicht, um eine Metallisierung von Teilen der Oberfläche vorzubereiten.

Es besteht der Bedarf, ein verbessertes Herstellungsverfahren für Schaltungsträger bereitzustellen, das eine Herstellung von dreidimensionalen Schaltungsträgern in Kleinserie ermöglicht.

### Zusammenfassung

"Additive Fertigungstechnologien" bieten das Potential, die Herausforderungen nach schnellen Reaktionszeiten und hoher Flexibilität bei kleinen Stückzahlen wirkungsvoll zu begegnen und somit die industrielle Produktion tiefgreifend zu verändern. Speziell in der Stereolithographie, bei der mittels lichthärtender Photopolymere (etwa im ultravioletten und/oder im sichtbaren Bereich) dreidimensionale Strukturen schichtweise hergestellt werden, sind eine Vielzahl leistungsfähigen Produkten herstellbar. Dieses formlose Herstellungsverfahren ermöglicht einen kostengünstigen und qualitativ hochwertigen "3D-Druck" von komplexen Kunststoff-Bauteilen in kleinen Stückzahlen bis hinunter zu Losgröße 1.

Genau hier setzen Ausführungsbeispiele an. Ziel ist die Kombination des additiven Fertigungsverfahrens Stereolithographie, welches im Folgenden als SL oder SLA (SLA ist die geschützte Bezeichnung eines Herstellers von 3D-Druckern. Im Folgenden werden die Begriffe austauschbar verwendet, d.h. unter dem Begriff SLA werden auch stereolithographische Herstellungsverfahren anderer Hersteller verstanden) bezeichnet wird, und der Technologie MID. Diese Kombination ermöglicht die partielle Metallisierung von additiv gefertigten Kunststoffbauteilen in einem formlosen Herstellungsprozess. Der individuell hergestellte Schaltungsträger kann anschließend mit elektronischen Komponenten direkt bestückt und somit elektrisch / elektronisch funktionalisiert werden.

Durch diese Fusion kann der Funktionsumfang eines Bauteils deutlich vergrößert, die Integrationsdichte erhöht sowie die Zuverlässigkeit durch Einsparung von zusätzlichen Montageso- wie Justageschritten verbessert werden. Im Hinblick auf kleine Losgrößen ist die Kombination aus additiver Fertigung eines Grundkörpers sowie der anschließenden selektiven Metallisierung mittels Laser (in einem Laserstrukturierungsverfahren wie etwa der Laser-Direkt-Strukturierung. Dabei hat der Laser eine subtraktive und thermische Wirkung) und stromloser Galvanik vorteilhaft, da die kostenintensive Spritzgussform eingespart wird.

Die Basis ist in zumindest manchen Ausführungsbeispielen ein UV-härtendes Photopolymer, welches gleichzeitig IR- Laser sensitive Pigmente (Additive), sog. Mischoxide (wie z.B. Kupfer-Phosphate, Titan-Oxid sowie Glimmer und Zinn-Antimon-Oxid), beinhaltet, welche mittels IR-Laserstrahlung reduziert werden können. Anschließend können in einem chemischen Prozess, an diesen mittels IR-Strahlung aktivierten Stellen Metallionen, wie z.B. Kupfer, anwachsen, um die entsprechenden metallischen Leiterbahnen auszubilden.

Ausführungsbeispiele schaffen sowohl die Formulierung des sog. MID-Harzes, welche aus einen UV-härtenden Photopolymer, sowie Zuschlagsstoffen (Additiven) in Form von IR-sensitiven Additiven (wie etwa Mischoxiden) bestehen kann als auch den gesamten Herstellungsprozess des stereolithographisch gefertigten MID-Schaltungsträger bzw. Bauteils.

Ausführungsbeispiele schaffen ein Herstellungsverfahren zum Herstellen eines dreidimensionalen Schaltungsträgers. Das Herstellungsverfahren umfasst ein Herstellen eines Grundkörpers des dreidimensionalen Schaltungsträgers mittels eines stereolithographischen Fertigungsverfahrens. Der Grundkörper wird aus einer Kunststoffmischung hergestellt. Die Kunststoffmischung umfasst ein Photopolymer und ein Additiv. Das Herstellen des Grundkörpers umfasst ein Bestrahlen des Grundkörpers mit Licht in einem ersten Wellenlängenbereich, um das Kunststoffgemisch zu dem Grundkörper zu härten. Das Additiv ist dazu ausgelegt, eine Laser-Strukturierung unter Bestrahlung mit einem Laser in einem zweiten Wellenlängenbereich zu ermöglichen, bei der laseraktivierbare Verbindungen in der Kunststoffmischung aktiviert werden. Der zweite Wellenlängenbereich ist von dem ersten Wellenlängenbereich verschieden. Das Herstellungsverfahren umfasst ferner ein Herstellen von ein oder mehreren Leiterstrukturen auf dem Grundkörper durch Laseraktivieren eines Teils einer Oberfläche des Grundkörpers mittels eines Lasers, und Metallisieren des laseraktivierten Teils der Oberfläche des Grundkörpers. Die Metallisierung bildet die ein oder mehreren Leiterstrukturen.

Durch Nutzen des Additivs in der Kunststoffmischung, das unter Laserbestrahlung in dem zweiten Wellenlängenbereich aktiviert werden kann, kann das Stereolithographische Verfahren genutzt werden, um dreidimensionale Schaltungsträger herzustellen.

In Ausführungsbeispielen können der erste Wellenlängenbereich und der zweite Wellenlängenbereich disjunkt sein, d.h. der erste und der zweite Wellenlängenbereich können sich nicht überschneiden. Beispielsweise kann der erste Wellenlängenbereich zumindest teilweise den Wellenlängenbereich von 380 nm bis 600 nm schneiden. Eine untere Schwelle des zweiten Wellenlängenbereichs kann zumindest 850 nm betragen. Beispielsweise kann das Laseraktivieren mit einem Laser im zweiten Wellenlängenbereich durchgeführt werden. Die Härtung der Kunststoffmischung kann mittels einer Lichtquelle im ersten Wellenlängenbereich durchgeführt werden. Die Wellenlängen des ersten Wellenlängenbereichs können kürzer sein als die Wellenlängen des zweiten Wellenlängenbereichs. Damit kann der Grundkörper einerseits durch Licht im ersten Wellenlängenbereich gehärtet werden und durch Licht im zweiten Wellenlängenbereich aktiviert werden, um die Leiterstrukturen auszubilden.

Das Additiv kann dazu ausgelegt sein, unter Strahlung im zweiten Wellenlängenbereich Metall-Keime abzuspalten. An die Metallkeime kann die Metallisierung angewachsen werden.

Das Additiv kann in zumindest einigen Ausführungsbeispielen ein Mischoxid umfassen. Beispielsweise kann das Additiv ein Mischoxid der Gruppe von Kupfer-Phosphat, Titan-Oxid, Zinn-Antimon-Oxid und Glimmer umfassen. Solche Additive ermöglichen beispielsweise ein Anwachsen einer Metallisierung, etwa einer Kupfer-Metallisierung.

In zumindest einigen Ausführungsbeispielen kann der Grundkörper in einem Behältnis aus der flüssigen Kunststoffmischung hergestellt werden. Das Herstellungsverfahren kann ferner ein Durchmischen der Kunststoffmischung während des Herstellungsvorgangs im Behältnis umfassen, um eine homogene Verteilung der Additive in der Kunststoffmischung zu erreichen. Dies ermöglicht eine gleichmäßige Verteilung der Additive in der Kunststoffmischung, und damit auch eine gleichmäßige (selektive) Aktivierung der Oberfläche des Grundkörpers.

Beispielsweise kann die Metallisierung mittels einer stromlosen Galvanik durchgeführt werden. So kann das das Metallisieren des laseraktivierten Teils der Oberfläche des Grundkörpers ein Aufbringen einer Kupferschicht, insbesondere ein Anwachsen einer Kupferschicht, auf den laseraktivierten Teils der Oberfläche des Grundkörpers umfassen. Durch die Kupferschicht können niederohmige Leiterstrukturen realisiert werden. Das Metallisieren des laseraktivierten Teils der Oberfläche kann ferner ein Passivieren der Kupferschicht umfassen, etwa um ein Oxidieren der Kupferschicht zu vermeiden. Beispielsweise kann das Metallisieren des laseraktivierten Teils der Oberfläche ein Passivieren der Kupferschicht durch Aktivieren der Kupferschicht durch Palladium, ein Aufbringen einer Nickelschicht auf die aktivierte Kupferschicht und ein Aufbringen einer Goldschicht auf die Nickelschicht umfassen. Dies stellt eine mögliche Passivierung der Kupferschicht dar. Außerdem hat das Aufbringen der Goldschicht Vorteile bei der Kontaktierung der Leiterstruktur.

In manchen Ausführungsbeispielen kann das Herstellungsverfahren ferner ein Tempern des dreidimensionalen Schaltungsträgers und/oder eine weitere Bestrahlung mit Licht im ersten Wellenlängenbereich nach dem Herstellen der ein oder mehreren Leiterstrukturen umfassen. Damit verbessert sich die chemische Vernetzung des Photopolymers, wodurch sich die mechanische Festigkeit deutlich steigern lässt.

Beispielsweise kann das Aktivieren der Oberfläche des Grundkörpers ein Aufrauen der Oberfläche des Grundkörpers und/oder ein chemisches Aktivieren der Additive an der Oberfläche des Grundkörpers umfassen. Dies ermöglicht das Anwachsen der Metallisierung an den aktivierten Stellen.

Ausführungsbeispiele schaffen ferner einen dreidimensionalen Schaltungsträger. Der dreidimensionale Schaltungsträger umfasst einen Grundkörper, der in einem stereolithographischen Fertigungsverfahren hergestellt ist. Der Grundkörper ist aus einer Kunststoffmischung hergestellt. Die Kunststoffmischung umfasst ein Photopolymer und ein Additiv. Das Photopolymer ist dazu ausgelegt, unter einer Bestrahlung mit Licht in einem ersten Wellenlängenbereich zu härten. Das Additiv ist dazu ausgelegt, eine Laser-Strukturierung unter Bestrahlung mit einem Laser in einem zweiten Wellenlängenbereich zu ermöglichen, bei der laseraktivierbare Verbindungen in der Kunststoffmischung aktiviert werden. Der zweite Wellenlängenbereich ist von dem ersten Wellenlängenbereich verschieden. Der dreidimensionale Schaltungsträger umfasst ein oder mehrere Leiterstrukturen, die auf dem Grundkörper angeordnet sind. Die ein oder mehreren Leiterstrukturen sind durch Laseraktivieren eines Teils einer Oberfläche des Grundkörpers mittels des Lasers und Metallisieren des laseraktivierten Teils der Oberfläche des Grundkörpers hergestellt. Die Metallisierung bildet die ein oder mehreren Leiterstrukturen.

Ausführungsbeispiele schaffen ferner ein computerimplementiertes Verfahren zum Generieren von Steuerungsanweisungen für einen Laser. Das Verfahren umfasst ein Erhalten eines dreidimensionalen Entwurfsmodells eines stereolithografischen Herstellungsverfahrens. Das Verfahren umfasst ein Generieren der Steuerungsanweisungen für den Laser basierend auf dem dreidimensionalen Entwurfsmodell des stereolithografischen Herstellungsverfahrens. Die Steuerungsanweisungen sind dazu ausgelegt, eine Oberfläche eines Grundkörpers, der durch das dreidimensionale Entwurfsmodell definiert ist, durch eine Bestrahlung durch den Laser selektiv zu aktivieren. Dies ermöglicht eine Nutzung der Entwurfsdaten des 3D-Drucks in der Steuerung des Lasers.

Ausführungsbeispiele schaffen ferner eine Kunststoffmischung zur Verwendung in einem stereolithografischen Herstellungsverfahren. Die Kunststoffmischung umfasst ein Photopolymer. Das Photopolymer ist dazu ausgelegt, unter Bestrahlung mit Licht in einem ersten Wellenlängenbereich zu härten. Die Kunststoffmischung umfasst ein Additiv. Das Additiv ist dazu ausgelegt, eine Laser-Strukturierung unter Bestrahlung mit einem Laser in einem zweiten Wellenlängenbereich zu ermöglichen, bei der laseraktivierbare Verbindungen in der Kunststoffmischung aktiviert werden. Der zweite Wellenlängenbereich ist von dem ersten Wellenlängenbereich verschieden. Ausführungsbeispiele schaffen ferner eine Nutzung der Kunststoffmischung in einem stereolithografischen Herstellungsverfahren.

### Figurenkurzbeschreibung

Einige Beispiele von Vorrichtungen und/oder Verfahren werden nachfolgend bezugnehmend auf die beiliegenden Figuren lediglich beispielhaft näher erläutert. Es zeigen:
- Fign. 1a und 1b: zeigen Flussdiagramme von Ausführungsbeispielen eines Herstellungsverfahrens zum Herstellen eines dreidimensionalen Schaltungsträgers;
- Fig. 1c: zeigt ein schematisches Diagramm eines dreidimensionalen Schaltungsträgers;
- Fig. 2: zeigt ein Flussdiagramm eines Ausführungsbeispiels eines computerimplementierten Verfahrens zum Generieren von Steuerungsanweisungen für einen Laser;
- Fig. 3: zeigt ein Flussdiagramm eines Ausführungsbeispiels eines Herstellungsverfahrens oder Herstellungsprozesses für ein additiv gefertigtes MID-Bauteil, das auf einer Kombination von Stereolithographie und Laser-Direkt-Strukturierung basiert;
- Fig. 4a und 4b: zeigen einen Grundkörper, der in einem stereolithographischen Verfahren gefertigt ist; und
- Fig. 5: zeigt ein schematisches Diagramm eines Grundkörpers eines dreidimensionalen Schaltungsträgers, wobei der Grundkörper selektiv Laseraktiviert ist.

### Beschreibung

Verschiedene Beispiele werden nun ausführlicher Bezug nehmend auf die beiliegenden Figuren beschrieben, in denen einige Beispiele dargestellt sind. In den Figuren können die Stärken von Linien, Schichten und/oder Bereichen zur Verdeutlichung übertrieben sein.

Während sich weitere Beispiele für verschiedene Modifikationen und alternative Formen eignen, sind dementsprechend einige bestimmte Beispiele derselben in den Figuren gezeigt und werden nachfolgend ausführlich beschrieben. Allerdings beschränkt diese detaillierte Beschreibung weitere Beispiele nicht auf die beschriebenen bestimmten Formen. Weitere Beispiele können alle Modifikationen, Entsprechungen und Alternativen abdecken, die in den Rahmen der Offenbarung fallen. Gleiche oder ähnliche Bezugszeichen beziehen sich in der gesamten Beschreibung der Figuren auf gleiche oder ähnliche Elemente, die bei einem Vergleich miteinander identisch oder in modifizierter Form implementiert sein können, während sie die gleiche oder eine ähnliche Funktion bereitstellen.

Es versteht sich, dass, wenn ein Element als mit einem anderen Element "verbunden" oder "gekoppelt" bezeichnet wird, die Elemente direkt, oder über ein oder mehrere Zwischenelemente, verbunden oder gekoppelt sein können. Wenn zwei Elemente A und B unter Verwendung eines "oder" kombiniert werden, ist dies so zu verstehen, dass alle möglichen Kombinationen offenbart sind, d. h. nur A, nur B sowie A und B, sofern nicht explizit oder implizit anders definiert. Eine alternative Formulierung für die gleichen Kombinationen ist "zumindest eines von A und B" oder "A und/oder B". Das Gleiche gilt, mutatis mutandis, für Kombinationen von mehr als zwei Elementen.

Die Terminologie, die hier zum Beschreiben bestimmter Beispiele verwendet wird, soll nicht begrenzend für weitere Beispiele sein. Wenn eine Singularform, z. B. "ein, eine" und "der, die, das" verwendet wird und die Verwendung nur eines einzelnen Elements weder explizit noch implizit als verpflichtend definiert ist, können weitere Beispiele auch Pluralelemente verwenden, um die gleiche Funktion zu implementieren. Wenn eine Funktion nachfolgend als unter Verwendung mehrerer Elemente implementiert beschrieben ist, können weitere Beispiele die gleiche Funktion unter Verwendung eines einzelnen Elements oder einer einzelnen Verarbeitungsentität implementieren. Es versteht sich weiterhin, dass die Begriffe "umfasst", "umfassend", "aufweist" und/oder "aufweisend" bei Gebrauch das Vorhandensein der angegebenen Merkmale, Ganzzahlen, Schritte, Operationen, Prozesse, Elemente, Komponenten und/oder einer Gruppe derselben präzisieren, aber nicht das Vorhandensein oder das Hinzufügen eines oder mehrerer anderer Merkmale, Ganzzahlen, Schritte, Operationen, Prozesse, Elemente, Komponenten und/einer Gruppe derselben ausschließen.

Sofern nicht anderweitig definiert, werden alle Begriffe (einschließlich technischer und wissenschaftlicher Begriffe) hier in ihrer üblichen Bedeutung auf dem Gebiet verwendet, zu dem Beispiele gehören.

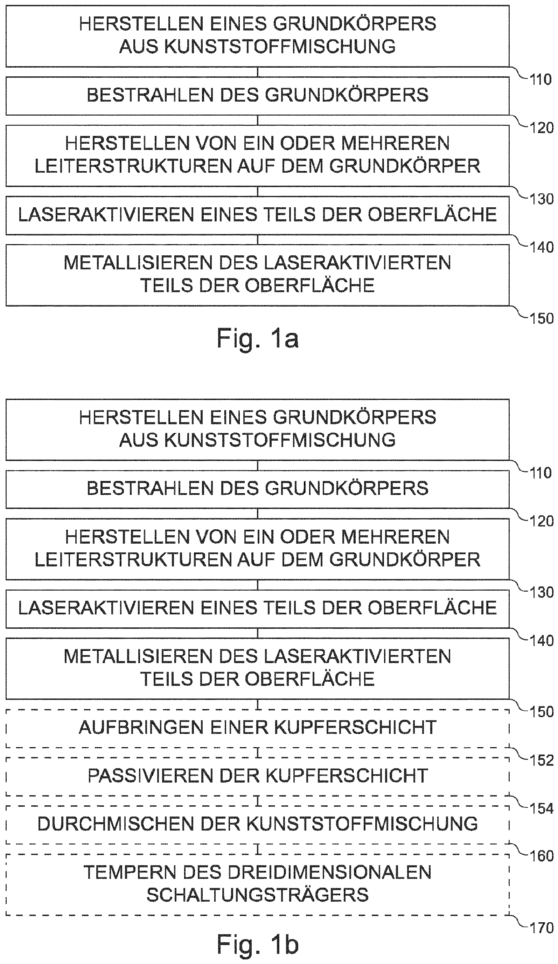

Fign. 1a und 1b zeigen Flussdiagramme von Ausführungsbeispielen eines Herstellungsverfahren zum Herstellen eines dreidimensionalen Schaltungsträgers 100. Das Herstellungsverfahren umfasst ein Herstellen 110 eines Grundkörpers 10 des dreidimensionalen Schaltungsträgers mittels eines stereolithographischen Fertigungsverfahrens. Der Grundkörper wird aus einer Kunststoffmischung hergestellt. Die Kunststoffmischung umfasst ein Photopolymer und ein Additiv. Das Herstellen des Grundkörpers 10 umfasst ein Bestrahlen 120 des Grundkörpers mit Licht in einem ersten Wellenlängenbereich, um das Kunststoffgemisch zu dem Grundkörper zu härten. Das Additiv ist dazu ausgelegt, eine Laser-Strukturierung unter Bestrahlung mit einem Laser in einem zweiten Wellenlängenbereich zu ermöglichen, bei der laseraktivierbare Verbindungen in der Kunststoffmischung aktiviert werden. Der zweite Wellenlängenbereich ist von dem ersten Wellenlängenbereich verschieden. Das Herstellungsverfahren umfasst ferner ein Herstellen 130 von ein oder mehreren Leiterstrukturen 20 auf dem Grundkörper 10 durch Laseraktivieren 140 eines Teils einer Oberfläche des Grundkörpers 10 mittels eines Lasers, und Metallisieren 150 des laseraktivierten Teils der Oberfläche des Grundkörpers. Die Metallisierung bildet die ein oder mehreren Leiterstrukturen.

Fig. lczeigt ein schematisches Diagramm eines dreidimensionalen Schaltungsträgers 100. Der dreidimensionale Schaltungsträger 100 umfasst einen Grundkörper 10. Der Grundkörper 10 ist in einem stereolithographischen Fertigungsverfahren hergestellt. Der Grundkörper ist aus einer Kunststoffmischung hergestellt. Die Kunststoffmischung umfasst ein Photopolymer und ein Additiv. Das Photopolymer ist dazu ausgelegt, unter einer Bestrahlung mit Licht in einem ersten Wellenlängenbereich zu härten. Das Additiv ist dazu ausgelegt, eine Laser-Strukturierung unter Bestrahlung mit einem Laser in einem zweiten Wellenlängenbereich zu ermöglichen, bei der laseraktivierbare Verbindungen in der Kunststoffmischung aktiviert werden. Der zweite Wellenlängenbereich ist von dem ersten Wellenlängenbereich verschieden ist. Der dreidimensionale Schaltungsträger 100 umfasst ein oder mehrere Leiterstrukturen 20. Die ein oder mehreren Leiterstrukturen ist/sind auf dem Grundkörper angeordnet. Die ein oder mehreren Leiterstrukturen sind durch Laseraktivieren eines Teils einer Oberfläche des Grundkörpers mittels des Lasers und Metallisieren des laseraktivierten Teils der Oberfläche des Grundkörpers hergestellt. Die Metallisierung bildet die ein oder mehreren Leiterstrukturen.

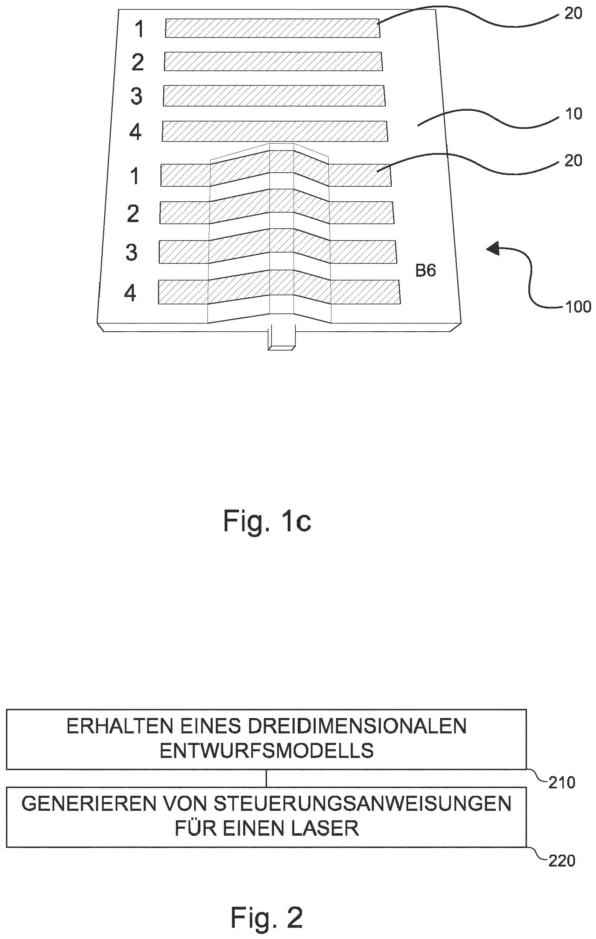

Die folgende Beschreibung bezieht sich sowohl auf das Herstellungsverfahren der Fign. 1a und 1b als auch auf den dreidimensionalen Schaltungsträger der Fig. 1c. Ferner bezieht sich die Beschreibung auf die Kunststoffmischung sowie auf eine Nutzung der Kunststoffmischung in einem stereolithographischen Verfahren.

Zumindest manche Ausführungsbeispiele beziehen sich auf ein Herstellungsverfahren zum Herstellen eines dreidimensionalen Schaltungsträgers, auf einen dreidimensionalen Schaltungsträger, auf eine Kunststoffmischung sowie auf eine Nutzung der Kunststoffmischung in einem stereolithographischen Herstellungsverfahren. Ausführungsbeispiele basieren dabei darauf, eine Kunststoffmischung in einem stereolithographischen Herstellungsverfahren zu nutzen, die neben einem Photopolymer ferner ein Additiv umfasst, das in einem additiven Laseraktivierungsverfahren genutzt werden kann, und das nach Laseraktivierung die Grundlage für eine selektive Metallisierung der Oberfläche des dreidimensionalen Schaltungsträgers bildet. Im Folgenden werden die Begriffe Additiv und Additive verwendet. Der Begriff Additiv soll dabei nicht darauf beschränkt werden, dass lediglich ein einziges Material als Additiv verwendet wird, es ist auch die Nutzung mehrerer Materialien im Additiv möglich. Auch soll der Begriff Additive nicht so verstanden werden, dass zwingend mehrere unterschiedliche Materialien in den Additiven vorhanden sein müssen. Im Folgenden werden die Begriffe Additiv und Additive zumindest synonym verwendet.

Dabei ist der dreidimensionale Schaltungsträger kein "flacher" Schaltungsträger wie etwa ein Printed Circuit Board (PCB, Gedruckter Schaltungsträger), sondern ein Schaltungsträger, bei dem zumindest eine Oberfläche nicht eben ist. Der dreidimensionale Schaltungsträger kann eine beliebig gekrümmte Oberfläche aufweisen, einschließlich einer planaren Struktur. Beispielsweise kann sich eine Höhe des Grundkörpers des dreidimensionalen Schaltungsträgers zwischen einer ersten Stelle des Grundkörpers und eine zweiten Stelle des Grundkörpers um zumindest 10% der Höhe des Grundkörpers an der ersten Stelle unterscheiden. Beispielsweise kann der Grundkörper des dreidimensionalen Schaltungsträgers an der Oberfläche Teilstrukturen umfassen, die aus einer Ebene, die von der Oberfläche des Grundkörpers gebildet wird, herausragen. In manchen Ausführungsbeispielen kann die Oberfläche des Grundkörpers konvex oder konkav ausgebildet sein. In zumindest einigen Ausführungsbeispielen ist der dreidimensionale Schaltungsträger nicht flach. Beispielsweise kann der dreidimensionale Schaltungsträger eine Höhe von zumindest 5 mm aufweisen. Dabei kann die Höhe Orthogonal zu einer größten Ausdehnung des dreidimensionalen Schaltungsträgers gemessen werden. Der dreidimensionale Schaltungsträger kann ähnlich wie ein Molded Interconnect Device ausgebildet sein, jedoch anders als dieser nicht in einem Gussverfahren, sondern in einem stereolithographischen Verfahren hergestellt sein.

Das Herstellungsverfahren umfasst das Herstellen 110 des Grundkörpers 10 des dreidimensionalen Schaltungsträgers mittels des stereolithographischen Fertigungsverfahrens. Die Stereolithographie ist ein additives Fertigungsverfahren, bei dem ein Werkstück durch frei im Raum materialisierende Punkte schichtenweise aufgebaut wird. Dabei wird das Werkstück, etwa der Grundkörper 10, meist in einem Behältnis mit einem flüssigen Photopolymer hergestellt. In Ausführungsbeispiele kann der Grundkörper 10 in einem Behältnis mit der flüssigen Kunststoffmischung hergestellt werden, d.h. die Kunststoffmischung kann beim Herstellen des Grundkörpers flüssig sein. Die Härtung der Kunststoffmischung kann mittels einer Lichtquelle im ersten Wellenlängenbereich durchgeführt werden. Durch gezielte Bestrahlung mit Licht im ersten Wellenlängenbereich, etwa durch eine Lichtquelle wie einen Laser, einen Projektor oder einen Flüssigkristallbildschirm, kann der Grundkörper gezielt ausgehärtet werden, so dass die Form des Grundkörpers (schichtweise) ausgebildet wird.

Die Kunststoffmischung umfasst ein Photopolymer und ein Additiv. Das Photopolymer kann beispielsweise ein Harz auf Basis von Acryl, Epoxid oder Vinylester sein. Das Herstellen des Grundkörpers 10 umfasst das Bestrahlen 120 des Grundkörpers mit Licht in dem ersten Wellenlängenbereich, um das Kunststoffgemisch zu dem Grundkörper zu härten. Beispielsweise kann das Photopolymer ein UV-härtendes Photopolymer sein. Viele Harze polymerisieren bei einer Wellenlänge von 405nm. Der erste Wellenlängenbereich kann zumindest teilweise den Wellenlängenbereich von 380 nm bis 600 nm schneiden. In anderen Worten kann der erste Wellenlängenbereich den Ultraviolett-Wellenlängenbereich und/oder den Wellenlängenbereich des sichtbaren Lichts schneiden. Der erste Wellenlängenbereich kann beispielsweise ein kurzwelliger Wellenlängenbereich sein (im Vergleich zum zweiten Wellenlängenbereich).

Beispielsweise kann das Bestrahlen des Grundkörpers mit Licht in dem ersten Wellenlängenbereich durch einen Laser, etwa einen UV-Laser, einen Projektor, oder einen Flüssigkristallbildschirm erfolgen.

Das Additiv ist dazu ausgelegt, eine Laser-Strukturierung unter Bestrahlung mit einem Laser in einem zweiten Wellenlängenbereich zu ermöglichen, bei der laseraktivierbare Verbindungen in der Kunststoffmischung aktiviert werden. Dabei umfasst das Aktivieren 140 der Oberfläche des Grundkörpers beispielsweise ein Aufrauen der Oberfläche des Grundkörpers und/oder ein chemisches Aktivieren der Additive an der Oberfläche des Grundkörpers. Beispielsweise kann das Additiv dazu ausgelegt sein, unter Strahlung im zweiten Wellenlängenbereich Metall-Keime abzuspalten. Die Abspaltung der Metall-Keime kann der Aktivierung entsprechen oder eine Folge der Aktivierung sein. Dabei kann die Kunststoffmischung etwa 0.05 bis 5 Volumen-Prozent, beispielsweise 2 bis 3 Volumen-Prozent, Additiv enthalten. Werden etwa Zinn-Oxide genutzt, so können bereits 0.05 bis 0.1 Volumen-Prozent ausreichen, bei anderen Additiven können höhere Volumenprozente benötigt werden. In anderen Worten kann das Additiv (oder die Additive, falls verschiedene Additive genutzt werden, die durch den Laser im zweiten Wellenlängenbereich aktiviert werden) 0.05 bis 5 Volumen-Prozent der Kunststoffmischung ausmachen. Folglich kann das Photopolymer zumindest 95% der Kunststoffmischung ausmachen. Das Photopolymer und das Additiv können homogen und klumpenfrei vermischt sein.

In zumindest einigen Ausführungsbeispielen umfasst das Additiv ein Mischoxid. Beispielsweise kann das Mischoxid ein Infrarot-sensitiv Mischoxid sein. Das Mischoxid kann so gewählt sein, dass es unter Strahlung im zweiten Wellenlängenbereich Metall-Keime abspaltet. Beispielsweise kann das Additiv ein Mischoxid der Gruppe von Kupfer-Phosphat, Titan-Oxid, Zinn-Antimon-Oxid und Glimmer umfassen.

Der zweite Wellenlängenbereich kann von dem ersten Wellenlängenbereich verschieden sein. In anderen Worten können sich in zumindest einigen Ausführungsbeispielen der erste Wellenlängenbereich und der zweite Wellenlängenbereich nicht überschneiden. Die Wellenlängen des ersten Wellenlängenbereichs können beispielsweise kürzer sein als die Wellenlängen des zweiten Wellenlängenbereichs. Beispielsweise kann der zweite Wellenlängenbereich dem Infrarot-Wellenlängenbereich entsprechen oder von dem Infrarot-Wellenlängenbereich umfasst sein. In anderen Worten kann eine untere Schwelle des zweiten Wellenlängenbereichs zumindest 850 nm betragen.

Das Verfahren umfasst ferner ein Herstellen 130 von ein oder mehreren Leiterstrukturen 20 auf dem Grundkörper 10. Beispielsweise können die ein oder mehreren Leiterstrukturen 20 an der Oberfläche des Grundkörpers angeordnet sein/hergestellt werden. Die ein oder mehreren Leiterstrukturen können beispielsweise ein oder mehrere Signal-Leiterbahnen (auch engl. signal traces) und/oder ein oder mehrere induktive Bauelemente (wie etwa Planar-Induktoren), kapazitive Bauelemente (etwa einen kapazitiven Sensor) oder resistive Bauelemente (wie etwa Mäander-Widerstände) umfassen oder bilden. Die Leiterstrukturen werden durch die Metallisierung gebildet. Beispielsweise kann die Metallisierung ein oder mehrere Zusammenhangskomponenten umfassen. Die ein oder mehreren Zusammenhangskomponenten können die ein oder mehreren Leiterstrukturen 20 bilden.

Das Herstellen der ein oder mehreren Leiterstrukturen 20 umfasst das Laseraktivieren 140 des Teils der Oberfläche des Grundkörpers 10 mittels des Lasers. Das Laseraktivieren 140 kann beispielsweise mit einem Laser im zweiten Wellenlängenbereich durchgeführt werden, beispielsweise mit einem Infrarot-Laser. Das Laseraktivieren kann beispielsweise ein Bestrahlen des Teils der Oberfläche mit dem Laser umfassen oder diesem entsprechen. Dabei kann beispielsweise lediglich ein Teil der Oberfläche des Grundkörpers mit dem Laser bestrahlt werden. Beispielsweise kann weniger als 95% (oder weniger als 90%, weniger als 85%, weniger als 80%) der Oberfläche des Grundkörpers mit dem Laser bestrahlt werden. Dabei kann beispielsweise eine Laserleistung von mehr als 6 W (etwa zwischen 8W und 14W), bei 80 bis 100kHz-Pulsfrequenz und 1m/s Schreibgeschwindigkeit. Der Quotient aus Laserleistung und Schreibgeschwindigkeit ist hierbei von Bedeutung und liefert in weiten Teilen identische Ergebnisse. Auf lokal eng begrenzten Arealen hat sich eine höhere Leistung bei höherer Schreibgeschwindigkeit als vorteilhaft erwiesen, da die thermische Belastung dadurch reduziert wird. Die Leistung hängt auch stark vom Laserdurchmesser auch, hier ca. 50µm bis 80µm. Daher ist die Energiedichte pro Zeit relevant und nicht die absoluten Werte. Damit kann die Laserleistung höher liegen als in konventionellen Laser-Direkt-Strukturierungen von MID-Bauteilen.

Das Herstellen der ein oder mehreren Leiterstrukturen umfasst ferner das Metallisieren 150 des laseraktivierten Teils der Oberfläche des Grundkörpers. Die Metallisierung 150 kann beispielsweise mittels einer stromlosen Galvanik (oder genereller mit einer stromlosen Beschichtung) durchgeführt werden. Zur Metallisierung kann beispielsweise Kupfer verwendet werden, beispielsweise als erste Metallisierungsschicht. In anderen Worten kann der laseraktivierte Teil der Oberfläche des Grundkörpers chemisch verkupfert werden. So kann beispielsweise das Metallisieren 150 des laseraktivierten Teils der Oberfläche des Grundkörpers ein Aufbringen 152 einer Kupferschicht, insbesondere ein Anwachsen einer Kupferschicht, auf den laseraktivierten Teils der Oberfläche des Grundkörpers umfassen, etwa durch die stromlose Galvanik. Dabei kann der laseraktivierte Grundkörper in einem Kupferbad, beispielsweise bei etwa 53°C für etwa 60 Minuten, chemisch verkupfert werden.

Das Metallisieren 150 des laseraktivierten Teils der Oberfläche kann ferner ein Passivieren 154 der Kupferschicht umfassen, etwa durch weitere Metallisierungen. Beispielsweise kann das Metallisieren des laseraktivierten Teils der Oberfläche ein Passivieren 154 der Kupferschicht durch Aktivieren der Kupferschicht durch Palladium, Aufbringen einer Nickelschicht auf die aktivierte Kupferschicht und Aufbringen einer Goldschicht oder einer Silberschicht auf die Nickelschicht umfassen. Alternativ kann der Grundkörper in manchen Ausführungsbeispielen nach Aufbringen der Kupferschicht in Harz (etwa Epoxy-Harz) vergossen werden oder nach dem Aufbringen der Kupfer-, Nickel-, Gold- oder Silberschicht mit einem Schutzlack gegen Korrosion und zum Schutz vor äußeren Einflüssen versiegelt werden.

In zumindest manchen Ausführungsbeispielen wird der Grundkörper 10 in einem Behältnis aus der flüssigen Kunststoffmischung hergestellt. Das Herstellungsverfahren kann ferner ein Durchmischen 160 der Kunststoffmischung während des Herstellungsvorgangs im Behältnis umfassen, um eine homogene Verteilung der Additive in der Kunststoffmischung zu erreichen. Beispielsweise kann eine Apertur genutzt werden, um die Kunststoffmischung ständig zu vermischen und das Additiv homogen in der Kunststoffmischung zu verteilen. Alternativ kann eine mechanische Vorrichtung, etwa ein Wischarm, genutzt werden, um die Kunststoffmischung im Behälter zu durchmischen. Homogen soll hierbei nicht absolut verstanden werden, jedoch soll durch das Durchmischen 160 der Kunststoffmischung die Homogenität der Verteilung des Additivs in der Kunststoffmischung erhöht werden.

In zumindest manchen Ausführungsbeispielen kann das Herstellungsverfahren ferner ein Tempern 170 (ein Erhitzen) des dreidimensionalen Schaltungsträgers nach dem Herstellen der ein oder mehreren Leiterstrukturen umfassen, etwa um die Festigkeit des dreidimensionalen Schaltungsträgers zu erhöhen. Alternativ oder zusätzlich kann das Herstellungsverfahren ferner ein weiteres Bestrahlen des dreidimensionalen Schaltungsträgers mit Licht im ersten Wellenlängenbereich nach dem Herstellen der ein oder mehreren Leiterstrukturen umfassen, etwa mit der gleichen Lichtquelle wie zuvor oder mit einer anderen Lichtquelle.

Mehr Details und Aspekte des Herstellungsverfahrens und/oder des dreidimensionalen Schaltungsträgers werden in Verbindung mit dem Konzept oder Beispielen genannt, die vorher oder nachher (z.B. Fign. 2 bis 5) beschrieben werden. Das Herstellungsverfahren und/oder der dreidimensionale Schaltungsträger kann ein oder mehrere zusätzliche optionale Merkmale umfassen, die ein oder mehreren Aspekten des vorgeschlagenen Konzepts oder der beschriebenen Beispiele entsprechen, wie sie vorher oder nachher beschrieben wurden.

Fig. 2 zeigt ein Flussdiagramm eines Ausführungsbeispiels eines computerimplementierten Verfahrens zum Generieren von Steuerungsanweisungen für einen Laser. Das Verfahren umfasst ein Erhalten 210 eines dreidimensionalen Entwurfsmodells eines stereolithografischen Herstellungsverfahrens. Beispielsweise kann das dreidimensionale Entwurfsmodell CAD-Daten (Computer Aided Design, Rechnergestützter Entwurf) oder CAM-Daten (Computer Aided Manufacturing, Rechnergestützte Herstellung) entsprechen. In stereolithografischen Herstellungsverfahren werden dabei häufig Daten in der sog. STL-Sprache (STereoLithografie oder auch Standard Triangulation/Tesselation Language, Standard Triangulations/Tesselations-Sprache) genutzt. Das Verfahren umfasst ferner ein Generieren 220 der Steuerungsanweisungen für den Laser basierend auf dem dreidimensionalen Entwurfsmodell des stereolithografischen Herstellungsverfahrens. Die Steuerungsanweisungen sind dazu ausgelegt, eine Oberfläche eines Grundkörpers, der durch das dreidimensionale Entwurfsmodell definiert ist, durch eine Bestrahlung durch den Laser selektiv zu aktivieren. Dabei kann das dreidimensionale Entwurfsmodell einen Grundkörper eines Werkstücks (etwa eines dreidimensionalen Schaltungsträgers) definieren. Das Generieren 220 der Steuerungsanweisungen kann dabei eine Anordnung und/oder einen Verlauf von ein oder mehreren Leiterstrukturen auf der Oberfläche des Grundkörpers in entsprechende Anweisungen für den Laser, der etwa ein Infrarot-Laser sein kann, umsetzen. Dabei können die Steuerungsanweisungen so generiert werden, dass an der Stelle, an der die ein oder mehreren Leiterstrukturen auf der Oberfläche des Grundkörpers angeordnet sind, der Laser angesteuert wird, um einen Laserstrahl zu emittieren, so dass die Stelle durch den Laserstrahl aktiviert wird (also die Stelle aufgeraut wird und/oder Additive in einer Kunststoffmischung des Grundkörpers an der Stelle chemisch aktiviert werden), etwa basierend auf einer vorgegebenen Laserleistung, basierend auf einem vorgegebenen Laserdurchmesser, basierend auf einem vorgegebenen Laserpulsfrequenz und/oder basierend auf einer vorgegebenen Schreibgeschwindigkeit. Dabei können beispielsweise die Stellen, an denen die ein oder mehreren Leiterstrukturen an der Oberfläche angeordnet sind, in ein Raster konvertiert werden, das als Grundlage für die Steuerungsanweisungen des Lasers genutzt wird (das sog. "Hatching").

Ausführungsbeispiele schaffen ferner ein Computerprogramm zur Durchführung des computerimplementierten Verfahrens, wenn das Computerprogramm auf einem Computer, einem Prozessor, oder einer programmierbaren Hardwarekomponente abläuft.

Mehr Details und Aspekte des Computerimplementierten Verfahrens werden in Verbindung mit dem Konzept oder Beispielen genannt, die vorher oder nachher (z.B. Fign. 1a bis 1c, 3 bis 5) beschrieben werden. Das Computerimplementierte Verfahren kann ein oder mehrere zusätzliche optionale Merkmale umfassen, die ein oder mehreren Aspekten des vorgeschlagenen Konzepts oder der beschriebenen Beispiele entsprechen, wie sie vorher oder nachher beschrieben wurden.

Zumindest manche Ausführungsbeispiele basieren auf zwei Bereichen von Technologien, etwa einerseits auf den Bereich der Molded Interconnect Device (MID) sowie in den Bereich der additiven Herstellung mittels stereolithographischer Verfahren (SLA).

Ein besonderes Merkmal der Technologie MID, die konventionell im Gussverfahren hergestellt wird, sind die unterschiedlichen Verfahren zur Herstellung der MID-Baugruppen. Zu den etablierten Verfahren zählen der Zweikomponentenspritzguss, die Laserstrukturierung und das Heißprägen. Weitere, nur für spezielle Anwendungen genutzte Verfahren, sind das Folienhinterspritzen und verschiedene Maskenbelichtungsverfahren. Die unterschiedlichen Verfahren werden jedoch durch gemeinsame Prozessstufen gekennzeichnet. Dabei verbindet der Begriff MID-Herstellverfahren die Prozesse Spritzgießen, Strukturieren und Metallisieren, die zur Erzeugung des MID-Grundkörpers notwendig sind. Die nachfolgenden Prozesse der Aufbau- und Verbindungstechnik (AVT) dienen der Aufbringung der elektronischen Komponenten auf dem Grundkörper. Die Zusammenführung aus Herstellverfahren und Aufbau- und Verbindungstechnik wird als MID- Prozesskette bezeichnet.

Das Basis-MID-Bauteil kann über 1- und 2-Komponenten-Spritzguss oder Folienhinterspritzen erstellt werden. Der wichtigste Schritt ist die Strukturierung der Schaltung. Drei Technologien sind weit verbreitet:
- 2K-Spritzguss: Bei zwei aufeinanderfolgenden Spritzgussschritten wird einmalig ein metallisierbares Polymer injiziert, um die Schaltungen zu realisieren.
- Laserstrukturierung: Ein Laser aktiviert bestimmte Teile des thermoplastischen Bauteils; additive und subtraktive Verfahren sind möglich.
- Heißprägen: Dieses Verfahren kombiniert die Strukturierung und Metallisierung in einem Schritt. Ein heißer Prägestempel presst eine Metallfolie auf das Basisteil und strukturiert dies dabei.
- ProtoPaint-Verfahren: In diesem Verfahren wird ein beliebiges Bauteil mit einem MID-fähigen Lack überzieht, um es anschließend mittels des LDS-Prozesses laseraktivieren und metallisieren zu können.

Der nächste Schritt in dem MID-Referenzprozess ist die Metallisierung des Bauteils. Dies kann mit chemischen, elektrochemischen oder Sputter-Techniken (Zerstäuber-Techniken), gemäß der erforderlichen Schichtdicke realisiert werden. Die Aufbringung der elektronischen Komponenten auf den Schaltungsträger erfordert unterschiedliche Technologien. Das Verfahren kann in die folgenden drei Schritte unterteilt werden:
- Aufbringung eines Verbindungsmediums (Lot oder Leitkleber)
- Positionierung der elektronischen Komponenten
- Verbindungsherstellung zwischen elektronischen Komponenten und Schaltungsträger

Die drei Stufen unterscheiden sich in ihren Merkmalen, gemäß der gewählten Anordnung der elektronischen Bauteile. Through Hole Devices (THD, Bauteile, die eine Durchkontaktierung benötigen) erfordern Durchkontaktierungen in der Oberfläche des thermoplastischen Schaltungsträgers, wohingegen Surface Mounted Devices (SMD, Bauteile, die an der Oberfläche angebracht sind) breite Kontakt- und Klebeflächen erfordern. Das Verbinden kann mit Hilfe von Drahtbonds, Blei oder Kontakt-Bumps, wie in Flip-Chips (FC, wörtlich umgedrehter Chip) beispielsweise, realisiert werden.

Die konventionelle Herstellung von MIDs basiert meist auf thermoplastischen Materialien, welche im Spritzgussverfahren zum MID-Schaltungsträger verarbeitet werden. Als Materialien werden beispielsweise ABS (Acrylnitril-Butadien-Styrol-Copolymer), COP (Cyclo Olefin Polymer), LCP (Liquid Crystal Polymer, Flüssigkristalline Polymere), PA (Polyamide), PC (Polycarbonate), PBT (Polybutylenterephthalat), PEEK (Polyetheretherketon), PEI (Polyetherimide), PPA (Polyphthalamide), PPE (Polyphenylenether) sowie PPS (Polyphenylensulfid) verwendet. Diese Kunststoffe werden im Spritzgussverfahren verarbeitet und eignen sich daher nicht zur formlosen Herstellung von Kleinserien mittels additiver Verfahren. Einige Materialien sind auch als FDM-Filamente (Fused Deposition Modeling, wörtlich Modellierung durch Schmelzablagerung, bezeichnet ein Fertigungsverfahren aus dem Bereich des Rapid Prototyping (Schnelles Prototyping), mit dem ein Werkstück schichtweise aus einem schmelzfähigen Kunststoff aufgebaut wird) am Markt erhältlich. Die Qualität und Oberflächentextur der mittels FDM-Verfahren hergestellten Bauteile ist jedoch nicht mit den im Spritzguss bzw. mittels SLA-Verfahren hergestellten Bauteilen vergleichbar und eignet sich daher nicht für qualitativ hochwertige sowie robuste MID-Bauteile.

Ausführungsbeispiele basieren auf der additiven Herstellung der Grundkörper mittels SLA-Verfahren. Als additive Fertigung wird ein Herstellungsverfahren bezeichnet, bei dem schichtweise ein Material aufgetragen wird. Typische Materialien sind Kunststoffe und Metall als Pulver, Granulate, am Stück oder in flüssiger Form. Im Rahmen von Ausführungsbeispielen wird das SL-Verfahren (Stereolithografie-Verfahren, auch SLA abgekürzt) genutzt, welches das älteste additive Fertigungsverfahren darstellt. SLA ist ein eine geschützte Bezeichnung von 3D Systems Inc., Rock Hill, South Carolina, USA. SLA-Drucker werden von verschiedenen Herstellern angeboten. Als Photopolymere werden Harze auf Basis von Acryl, Epoxid oder Vinylester eingesetzt. Diese werden von verschiedenen Herstellern am Markt angeboten. Die meisten Harze polymerisieren bei einer Wellenlänge von 405nm. Mittlerweile werden auch sog. "Day Light"-Harze angeboten ("Tageslicht"-Harze), welche mittels einen handelsüblichen LCD-Display belichtet werden. Hierbei erfolgt die Polymerisation im sichtbaren Bereich von 460nm (blau).

Ausführungsbeispiele basieren auf einer direkten Kombination der Technologen MID und SLA, auf Basis eines MID-kompatiblen Photopolymers.

Die Herstellung eines additiv gefertigten "LDS-Prozess kompatiblen" MID-Bauteils gliedert sich in manchen Ausführungsbeispielen in die im Folgenden beschriebenen Prozessschritte. Dabei kann der Prozess auch lediglich einen Teil der vorgestellten Schritte umfassen.

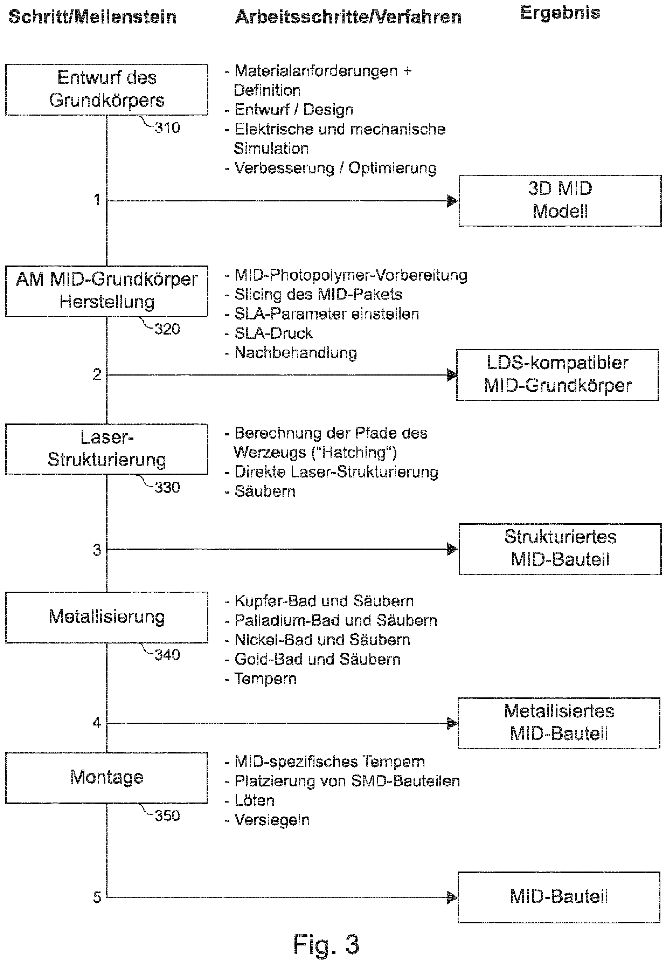

Fig. 3 zeigt ein Flussdiagramm eines Ausführungsbeispiels eines Herstellungsverfahrens oder Herstellungsprozesses für ein additiv gefertigtes MID-Bauteil, das auf einer Kombination von Stereolithographie und Laser-Direkt-Strukturierung basiert. Auch wenn das Bauteil nicht in einem Gussverfahren hergestellt wird, wird auch nachfolgend der Begriff MID beibehalten. Damit steht im Folgenden der Begriff MID nicht mehr zwangsläufig für spritzgegossene Bauteile. Die einzelnen Prozessschritte werden nachfolgend detailliert beschrieben. Kern der Erfindung ist sowohl die Kombination von Materialien und Herstellungsverfahren als auch die Durchführung der einzelnen Prozessschritte in der richtigen Reihenfolge und mit geeigneten Prozessparametern.

Entwurf des Grundkörpers (Bezugszeichen 310). Die Basis zur Herstellung einen funktionsfähigen MID-Bauteils bildet die Spezifikation der Anforderungen aus denen ein geeignetes mechanisches als auch elektrisches Design abgeleitet wird. Auf Basis der Spezifikation werden die entsprechenden Anforderungen an das zu Grunde liegenden Basismaterial - Photopolymer - abgeleitet. Hierbei sind neben den mechanischen Festigkeiten besonders der thermische Ausdehnungskoeffizient (CTE, Coefficient of Thermal Expansion) und die Temperaturbeständigkeit von besonderer Bedeutung, da diese das mögliche Design, die Aufbau und Verbindungstechnik sowie die Einsatzbedingungen des MID-Bauteils maßgeblich beeinflussen und definieren können.

Nach der Entwurfs-Phase (Design-Phase) kann eine optionale Simulation-Phase anschließen. In dieser Simulations-Phase wird das elektrische und mechanische sowie das thermische Verhalten des MID-Bauteils mittels nummerischer oder analytischer Methoden domänenspezifisch wie auch domänenübergreifend simuliert werden. Dadurch können Designfehler erkannt und korrigiert werden. Ebenfalls können Wechselwirkungen zwischen elektrischen, mechanischen und thermischen Verhalten eruiert und ggf. kompensiert bzw. reduziert werden. Die Verbesserung bzw. Optimierung der Eigenschaften des MID-Bauteils, wie z.B. die Resonanzfrequenz und die Abstrahlcharakteristik einer Antenne, ist mit Hilfe dieser Simulationsmodelle ebenfalls optional möglich. Resultat des Entwurfsschritts ist beispielsweise ein 3D-Modell des SLA-basierten MID-Bauteils.

AM MID (Additive Manufacturing MID, etwa ein 3D-gedruckter und nicht spritzgegossener MID-Grundkörper) Grundkörper-Herstellung (Bezugszeichen 320): Nach der Designphase, bei der die relevanten Parameter und Dimensionen spezifiziert und festgelegt wurden, erfolgt nun die additive Herstellung der MID-Grundkörpers mit Hilfe des SLA-Verfahrens. Kern der Erfindung ist die Formulierung eines geeigneten Photopolymers (etwa der Kunststoffmischung), welches sowohl unter UV-Licht polymerisiert (im ersten Wellenlängenbereich) als auch mittels IR-Strahlung (im zweiten Wellenlängenbereich) selektiv laseraktiviert werden kann, damit an diesen Stellen Kupfer-Atome nach dem LDS-Verfahren (Laser-Direkt-Strukturierung, ein Laser-Strukturierungsverfahren) anwachsen können.

Zunächst wird ein klares UV-polymerisierendes-Harz - hier exemplarisch ein Hochtemperatur Photopolymer (Methacrylsäureestern, etwa RS-F2-HTAM-02 von Formlabs Inc.) - mit einem Lasersensitiven Pigment (etwa dem Additiv) aus Titan-Oxiden und Zinn-Amonium-Oxiden (Alternativ auch ca. 90% Kupfer-Phospate und 10% Zinn-Antimon-Oxid oder ca. 60% Titanoxid und 40% Zinn-Antimon-Oxid) homogen und klumpenfrei vermischt. Es können auch andere Photopolymere eingesetzt werden (die kompatibel sind mit dem SLA-Drucker). Das Mischungsverhältnis beträgt bei Titan-Oxid/Zinn-Amonium-Oxid-Mischung beispielsweise ca. 2 bis 3%.

Nach entsprechender Parametrisierung des SLA-Druckers hinsichtlich Laserleistung und Belichtungszeit sowie dem schichtweisen Zerlegen des Volumenkörpers in einzeln Druckschichten - dem sog. Slicing - kann der 3D-Druck gestartet werden. Eine Apertur, welche das Harz ständig vermischt und die Partikel homogen im Harz verteilt, ist bei langandauernden Druckprozessen von Vorteil und erhöht deutlich die Qualität. In manchen Ausführungsbeispielen ist der 3D-Drucker mit einem Wischarm ausgestattet, welcher diese Durchmischung nach jeder Druckschicht gewährleistet. Eine Temperierung des Harzes auf die optimale Verarbeitungstemperatur (Ca. 32°C bei Formlabs RS-F2-HTAM-02, ansonsten abhängig vom verendeten Harz) ist ebenfalls von Vorteil und erhöht die Qualität es 3D-Druckes. Nach dem Druckprozess wird der LDS-kompatible MID-Grundkörper entnommen und gründlich von den nichtpolymerisierten Harzresten gereinigt.

Anschließend können die optionalen Stützstrukturen entfernt werden. Bedarfsweise kann der MID-Grundköper (etwa der Grundkörper) mittels Tempern oder/und UV-Bestrahlung nachbehandelt werden (das sog. "Curing"). Damit verbessert sich die chemische Vernetzung des Photopolymers, wodurch sich die mechanische Festigkeit deutlich steigern lässt. Ergebnis der Herstellung des Grundkörpers kann ein Grundkörper sein, der für die Laser-Direkt-Strukturierung geeignet ist.

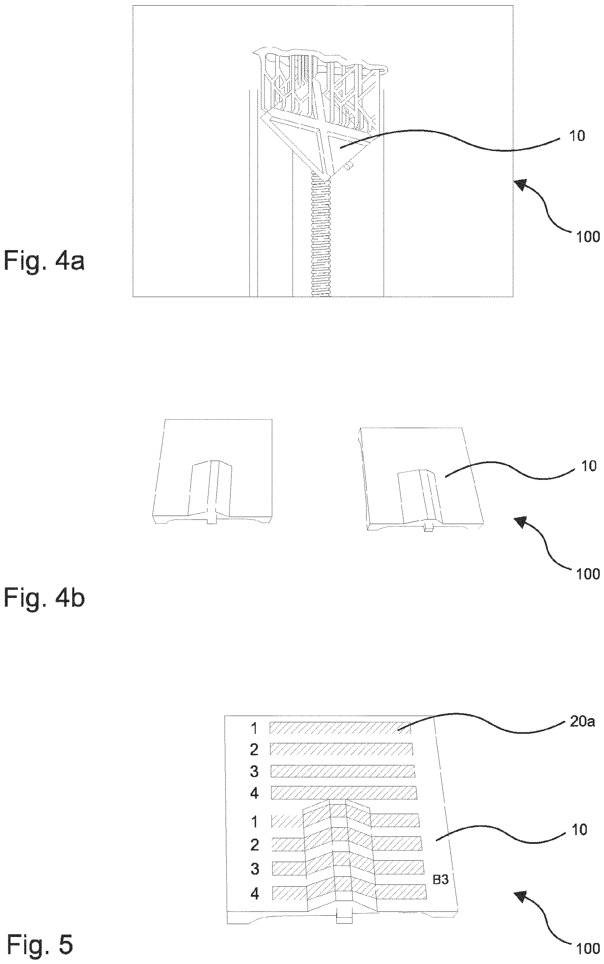

Fig. 4a und 4b zeigen einen Grundkörper, der in einem stereolithographischen Verfahren gefertigt ist. Fig. 4a zeigt den Grundkörper direkt nach dem SL-Druck, Fig. 4b nach der Reinigung und Nachbehandlung.

Laser-Strukturierung (Bezugszeichen 330): Die Layoutdaten des MID-Bauteils werden in Belichtungsdaten für den IR-Laser konvertiert - sog. Hatching. In Abhängigkeit von der Apertur bzw. des Laserdurchmessers werden die einzelnen Bahndaten berechnet, etwa die Steuerungsanweisungen für den Laser, wie sie im Zusammenhang mit Fig. 2 vorgestellt wurden. Diese Berechnung wurde exemplarisch mit dem Programm CircuitPro 3D des Herstellers LPKF durchgeführt. In Abhängigkeit des verwendeten Photopolymers und der eingemischten lasersensitiven Pigmente (MID-Additive, das Additiv) werden weitere Prozessparameter festgelegt, wie z.B. Laserleistung, Schreibgeschwindigkeit, Laserpulsfrequenz etc. Diese haben einen entscheidenden Einfluss auf die Qualität des Schichtaufbaus im nachfolgenden Metallisierungsprozess.

Bei dem hier eingesetzten Infrarot-Laser (Fusion3D von LPKF) mit 1064nm Wellenlänge, wurde bei einem Strahldurchmesser von 80µm mit einer Laserleistung von 8 bis 14W, bei 80 bis 100kHz-Pulsfrequenz und 1m/s Schreibgeschwindigkeit, die besten Ergebnisse erzielt. Abschließen kann das Bauteil intensiv gereinigt werden um die Ablationsrückstände der Laseraktivierung von der Oberfläche zu entfernen. Diese können die Metallisierung negativ beeinflussen.

Ergebnis der Laserstrukturierung ist ein strukturierter Grundkörper eines MID-Bauteils. Fig. 5 zeigt ein schematisches Diagramm eines Grundkörpers eines dreidimensionalen Schaltungsträgers, wobei der Grundkörper selektiv Laseraktiviert ist. Dabei bezeichnet Bezugszeichen 20a die Stellen, an der der Grundkörper laseraktiviert ist, und an denen später die ein oder mehreren Leiterstrukturen 20 durch Metallisierung hergestellt werden.

Metallisierung (Bezugszeichen 340). Die Metallisierung des laserstrukturierten und aktivierten MID-Bauteils erfolgt beispielhaft mittels stromloser Metallisierung nach dem sog. LPKF-LDS-Verfahren. Die Bad-Reihenfolge für die Metallisierung gestaltet sich wie folgt: Kupfer, Palladium, Nickel und Gold. Im ersten Schritt kann das laseraktivierte MID-Bauteil in Kupferbad bei 53°C für ca. 60 Minuten chemisch verkupfert werden. Dabei kann ca. 6 bis 10µm Kupfer auf den laseraktivierten Arealen abgeschieden werden. Nach einem intensiven Reinigungsschritt kann das Bauteil für ca. 2 min in das kalte Palladium-Bad verbracht werden, um die abgeschiedenen Kupferflächen mittels Palladiumkeimen zu aktivieren. Dieses ermöglicht den nachfolgenden Schritt der Vernickelung. Nach intensiver Reinigung kann das Bauteil nun für ca. 45 bis 60 Minuten bei ca. 60°C in das Nickel-Bad gehängt werden. Dabei kann eine Nickelschicht von ca. 4 bis 6µm Nickel chemisch abgeschieden werden. Nach einer weiteren Intensivreinigung kann der der nächste (der finale) Metallisierungsschritt bei 88°C für ca. 60 Minuten im Goldbad erfolgen. Hierbei werden ca. 0.1 µm Gold auf dem Nickel chemisch abgeschiedens. Die Goldschicht schützt die Oberfläche vor Oxidation und verbessert die Löt- bzw. Bond-Eigenschaften der Leiterbahnen. Das Ergebnis der Metallisierung ist in Fig. 1c dargestellt. Hier zeigt sich deutlich die detaillierte und trennscharfe Metallisierung auf dem mittels MID-Harz additiv hergestellten Testkörper. Fig. 1c zeigt ein Im SLA-Verfahren additiv hergestelltes MID-Bauteil nach dem Metallisierungsprozess im LPKF-LDS-Verfahren.

Montage (Bezugszeichen 350): Bevor mit der Bestückung des MID-Bauteils begonnen wird, kann das Bauteil noch ca. 30 bis 45min bei 55°C bis 60°C getempert werden (Temperatur und Dauer hängen auch von dem verwendetem Photopolymer ab). Dieser Prozessschritt verbessert die Verankerung des abgeschiedenen Metalls im der Kunststoffoberfläche. Des Weiteren werden dadurch ebenfalls die Löt- bzw. Bond-Eigenschaften der Leiterbahn verbessert. Danach kann das MID-Bauteil (der dreidimensionale Schaltungsträger) mit elektrischen und elektronischen Bauteilen bestückt werden. Wie bei konventionellen MID-Bauteilen können die elektrischen Verbindungen hierbei durch Leitkleben, Löten oder Drahtbonden hergestellt werden. Nach einer weiteren Reinigung zum Entfernen von etwaigen Löt- bzw. Leitkleberrückstände, kann das MID-Bauteil mit einem 2K-Lack (Zweikomponenten-Lack) versiegelt werden. Dadurch ist es neben chemischen auch gegen mechanische Umwelteinflüssen geschützt.

Zumindest einige Ausführungsbeispiele zeichnen sich dadurch aus, dass 3D-MID-Bauteile in kleinsten Losgrößen bis zur Stückzahl 1, individuell und kostengünstig hergestellt werden können. Maßgeblich dafür ist die Formulierung des MID-Photopolymers, welches die formlose Herstellung eines LDS-kompatiblen MID-Grundkörpers im Stereolithographie-Verfahren (SLA) ermöglicht. Dadurch eröffnen sich vielfältige Anwendungsmöglichkeiten für MID-Bauteile, welche vorher durch die hohen Initialkosten der Spritzgussform verwehrt blieben.

Die potentiellen Anwendungsgebiete sind vielfältig und können exemplarisch aus folgenden Bereichen stammen: Automobilindustrie, Luftfahrt, Medizin, Anlagen- und Maschinenbau, Sensorik, IoT-Devices und/oder Kundenspezifische Elektronik. Folglich ermöglichen Ausführungsbeispiele den Einsatz von 3D-MIDs in Anwendungsgebieten, die kleine Losgrößen voraussetzt bzw. bei denen die einzelnen Geräte individualisiert oder kundenspezifische hergestellt werden. In allen diesen Anwendungsfällen ist eine Spritzgussform unwirtschaftlich. Des Weiteren eignet sich das Verfahren für hochwertige MID-Prototypen sowie für die On-Demand-Fertigung von 3D-MID-Geräten.

Die Aspekte und Merkmale, die zusammen mit einem oder mehreren der vorher detaillierten Beispiele und Figuren beschrieben sind, können auch mit einem oder mehreren der anderen Beispiele kombiniert werden, um ein gleiches Merkmal des anderen Beispiels zu ersetzen oder um das Merkmal in das andere Beispiel zusätzlich einzuführen.

Beispiele können weiterhin ein Computerprogramm mit einem Programmcode zum Ausführen eines oder mehrerer der obigen Verfahren sein oder sich darauf beziehen, wenn das Computerprogramm auf einem Computer oder Prozessor ausgeführt wird. Schritte, Operationen oder Prozesse von verschiedenen, oben beschriebenen Verfahren können durch programmierte Computer oder Prozessoren ausgeführt werden. Beispiele können auch Programmspeichervorrichtungen, z. B. Digitaldatenspeichermedien, abdecken, die maschinen-, prozessor- oder computerlesbar sind und maschinenausführbare, prozessorausführbare oder computerausführbare Programme von Anweisungen codieren. Die Anweisungen führen einige oder alle der Schritte der oben beschriebenen Verfahren aus oder verursachen deren Ausführung.

Die Programmspeichervorrichtungen können z. B. Digitalspeicher, magnetische Speichermedien wie beispielsweise Magnetplatten und Magnetbänder, Festplattenlaufwerke oder optisch lesbare Digitaldatenspeichermedien umfassen oder sein. Weitere Beispiele können auch Computer, Prozessoren oder Steuereinheiten, die zum Ausführen der Schritte der oben beschriebenen Verfahren programmiert sind, oder (feld-)programmierbare Logik-Arrays ((F)PLAs = (Field) Programmable Logic Arrays) oder (feld-)programmierbare Gate-Arrays ((F)PGA = (Field) Programmable Gate Arrays), die zum Ausführen der Schritte der oben beschriebenen Verfahren programmiert sind, abdecken.

Durch die Beschreibung und Zeichnungen werden nur die Grundsätze der Offenbarung dargestellt. Weiterhin sollen alle hier aufgeführten Beispiele grundsätzlich ausdrücklich nur illustrativen Zwecken dienen, um den Leser beim Verständnis der Grundsätze der Offenbarung und der durch den (die) Erfinder beigetragenen Konzepte zur Weiterentwicklung der Technik zu unterstützen. Alle hiesigen Aussagen über Grundsätze, Aspekte und Beispiele der Offenbarung sowie konkrete Beispiele derselben umfassen deren Entsprechungen.

Ein als "Mittel zum..." Ausführen einer bestimmten Funktion bezeichneter Funktionsblock kann sich auf eine Schaltung beziehen, die ausgebildet ist zum Ausführen einer bestimmten Funktion. Somit kann ein "Mittel für etwas" als ein "Mittel ausgebildet für oder geeignet für etwas" implementiert sein, z. B. ein Bauelement oder eine Schaltung ausgebildet für oder geeignet für die jeweilige Aufgabe.

Funktionen verschiedener in den Figuren gezeigter Elemente einschließlich jeder als "Mittel", "Mittel zum Bereitstellen eines Signals", "Mittel zum Erzeugen eines Signals", etc. bezeichneter Funktionsblöcke kann in Form dedizierter Hardware, z. B "eines Signalanbieters", "einer Signalverarbeitungseinheit", "eines Prozessors", "einer Steuerung" etc. sowie als Hardware fähig zum Ausführen von Software in Verbindung mit zugehöriger Software implementiert sein. Bei Bereitstellung durch einen Prozessor können die Funktionen durch einen einzelnen dedizierten Prozessor, durch einen einzelnen gemeinschaftlich verwendeten Prozessor oder durch eine Mehrzahl von individuellen Prozessoren bereitgestellt sein, von denen einige oder von denen alle gemeinschaftlich verwendet werden können. Allerdings ist der Begriff "Prozessor" oder "Steuerung" bei Weitem nicht auf ausschließlich zur Ausführung von Software fähige Hardware begrenzt, sondern kann Digitalsignalprozessor-Hardware (DSP-Hardware; DSP = Digital Signal Processor), Netzprozessor, anwendungsspezifische integrierte Schaltung (ASIC = Application Specific Integrated Circuit), feldprogrammierbare Logikanordnung (FPGA = Field Programmable Gate Array), Nurlesespeicher (ROM = Read Only Memory) zum Speichern von Software, Direktzugriffsspeicher (RAM = Random Access Memory) und nichtflüchtige Speichervorrichtung (storage) umfassen. Sonstige Hardware, herkömmliche und/oder kundenspezifische, kann auch eingeschlossen sein.

Ein Blockdiagramm kann zum Beispiel ein grobes Schaltdiagramm darstellen, das die Grundsätze der Offenbarung implementiert. Auf ähnliche Weise können ein Flussdiagramm, ein Ablaufdiagramm, ein Zustandsübergangsdiagramm, ein Pseudocode und dergleichen verschiedene Prozesse, Operationen oder Schritte repräsentieren, die zum Beispiel im Wesentlichen in computerlesbarem Medium dargestellt und so durch einen Computer oder Prozessor ausgeführt werden, ungeachtet dessen, ob ein solcher Computer oder Prozessor explizit gezeigt ist. In der Beschreibung oder in den Patentansprüchen offenbarte Verfahren können durch ein Bauelement implementiert werden, das ein Mittel zum Ausführen eines jeden der jeweiligen Schritte dieser Verfahren aufweist.

Es versteht sich, dass die Offenbarung mehrerer, in der Beschreibung oder den Ansprüchen offenbarter Schritte, Prozesse, Operationen oder Funktionen nicht als in der bestimmten Reihenfolge befindlich ausgelegt werden soll, sofern dies nicht explizit oder implizit anderweitig, z. B. aus technischen Gründen, angegeben ist. Daher werden diese durch die Offenbarung von mehreren Schritten oder Funktionen nicht auf eine bestimmte Reihenfolge begrenzt, es sei denn, dass diese Schritte oder Funktionen aus technischen Gründen nicht austauschbar sind. Ferner kann bei einigen Beispielen ein einzelner Schritt, Funktion, Prozess oder Operation mehrere Teilschritte, -funktionen, -prozesse oder -operationen einschließen und/oder in dieselben aufgebrochen werden. Solche Teilschritte können eingeschlossen sein und Teil der Offenbarung dieses Einzelschritts sein, sofern sie nicht explizit ausgeschlossen sind.

Weiterhin sind die folgenden Ansprüche hiermit in die detaillierte Beschreibung aufgenommen, wo jeder Anspruch als getrenntes Beispiel für sich stehen kann. Während jeder Anspruch als getrenntes Beispiel für sich stehen kann, ist zu beachten, dass - obwohl ein abhängiger Anspruch sich in den Ansprüchen auf eine bestimmte Kombination mit einem oder mehreren anderen Ansprüchen beziehen kann - andere Beispiele auch eine Kombination des abhängigen Anspruchs mit dem Gegenstand jedes anderen abhängigen oder unabhängigen Anspruchs umfassen können. Solche Kombinationen werden hier explizit vorgeschlagen, sofern nicht angegeben ist, dass eine bestimmte Kombination nicht beabsichtigt ist. Ferner sollen auch Merkmale eines Anspruchs für jeden anderen unabhängigen Anspruch eingeschlossen sein, selbst wenn dieser Anspruch nicht direkt abhängig von dem unabhängigen Anspruch gemacht ist.

## Patentansprüche

1. Herstellungsverfahren zum Herstellen eines dreidimensionalen Schaltungsträgers (100), das Herstellungsverfahren umfassend:
Herstellen (110) eines Grundkörpers (10) des dreidimensionalen Schaltungsträgers mittels eines stereolithographischen Fertigungsverfahrens,
wobei der Grundkörper aus einer Kunststoffmischung hergestellt wird,
wobei die Kunststoffmischung ein Photopolymer und ein Additiv umfasst,
wobei das Herstellen des Grundkörpers (10) ein Bestrahlen (120) des Grundkörpers mit Licht in einem ersten Wellenlängenbereich umfasst, um das Kunststoffgemisch zu dem Grundkörper zu härten,
wobei das Additiv dazu ausgelegt ist, eine Laser-Strukturierung unter Bestrahlung mit einem Laser in einem zweiten Wellenlängenbereich zu ermöglichen, bei der laseraktivierbare Verbindungen in der Kunststoffmischung aktiviert werden, wobei der zweite Wellenlängenbereich von dem ersten Wellenlängenbereich verschieden ist;
Herstellen (130) von ein oder mehreren Leiterstrukturen (20) auf dem Grundkörper (10) durch Laseraktivieren (140) eines Teils einer Oberfläche des Grundkörpers (10) mittels eines Lasers, und Metallisieren (150) des laseraktivierten Teils der Oberfläche des Grundkörpers,
wobei die Metallisierung die ein oder mehreren Leiterstrukturen bildet.

2. Das Herstellungsverfahren gemäß Anspruch 1, wobei sich der erste Wellenlängenbereich und der zweite Wellenlängenbereich nicht überschneiden,
und/oder wobei der erste Wellenlängenbereich zumindest teilweise den Wellenlängenbereich von 380 nm bis 600 nm schneidet,
und/oder wobei eine untere Schwelle des zweiten Wellenlängenbereichs zumindest 850 nm beträgt.

3. Das Herstellungsverfahren gemäß einem der vorhergehenden Ansprüche, wobei das Laseraktivieren (140) mit einem Laser im zweiten Wellenlängenbereich durchgeführt wird, wobei die Härtung der Kunststoffmischung mittels einer Lichtquelle im ersten Wellenlängenbereich durchgeführt wird, wobei die Wellenlängen des ersten Wellenlängenbereichs kürzer sind als die Wellenlängen des zweiten Wellenlängenbereichs.

4. Das Herstellungsverfahren gemäß einem der vorherigen Ansprüche, wobei das Additiv dazu ausgelegt ist, unter Strahlung im zweiten Wellenlängenbereich Metall-Keime abzuspalten.

5. Das Herstellungsverfahren gemäß einem der vorhergehenden Ansprüche, wobei das Additiv ein Mischoxid umfasst.

6. Das Herstellungsverfahren gemäß einem der vorhergehenden Ansprüche, wobei das Additiv ein Mischoxid der Gruppe von Kupfer-Phosphat, Titan-Oxid, Zinn-Antimon-Oxid und Glimmer umfasst.

7. Das Herstellungsverfahren gemäß einem der vorhergehenden Ansprüche, wobei der Grundkörper (10) in einem Behältnis aus der flüssigen Kunststoffmischung hergestellt wird, wobei das Herstellungsverfahren ferner ein Durchmischen (160) der Kunststoffmischung während des Herstellungsvorgangs im Behältnis umfasst, um eine homogene Verteilung der Additive in der Kunststoffmischung zu erreichen.

8. Das Herstellungsverfahren gemäß einem der vorhergehenden Ansprüche, wobei die Metallisierung (150) mittels einer stromlosen Galvanik durchgeführt wird.

9. Das Herstellungsverfahren gemäß einem der vorhergehenden Ansprüche, wobei das Metallisieren (150) des laseraktivierten Teils der Oberfläche des Grundkörpers ein Aufbringen (152) einer Kupferschicht, insbesondere ein Anwachsen einer Kupferschicht, auf den laseraktivierten Teils der Oberfläche des Grundkörpers umfasst.

10. Das Herstellungsverfahren gemäß Anspruch 9, wobei das Metallisieren (150) des laseraktivierten Teils der Oberfläche ein Passivieren (154) der Kupferschicht umfasst.

11. Das Herstellungsverfahren gemäß Anspruch 9, wobei das Metallisieren des laseraktivierten Teils der Oberfläche ein Passivieren (154) der Kupferschicht durch Aktivieren der Kupferschicht durch Palladium, Aufbringen einer Nickelschicht auf die aktivierte Kupferschicht und Aufbringen einer Goldschicht auf die Nickelschicht umfasst.

12. Das Herstellungsverfahren gemäß einem der vorhergehenden Ansprüche, ferner umfassend Tempern (170) des dreidimensionalen Schaltungsträgers nach dem Herstellen der ein oder mehreren Leiterstrukturen.

13. Das Herstellungsverfahren gemäß einem der vorhergehenden Ansprüche, wobei das Aktivieren (140) der Oberfläche des Grundkörpers ein Aufrauen der Oberfläche des Grundkörpers und/oder ein chemisches Aktivieren der Additive an der Oberfläche des Grundkörpers umfasst.

14. Dreidimensionaler Schaltungsträger (100) umfassend:
ein Grundkörper (10), der in einem stereolithographischen Fertigungsverfahren hergestellt ist, wobei der Grundkörper aus einer Kunststoffmischung hergestellt ist, wobei die Kunststoffmischung ein Photopolymer und ein Additiv umfasst, wobei das Photopolymer dazu ausgelegt ist, unter einer Bestrahlung mit Licht in einem ersten Wellenlängenbereich zu härten, wobei das Additiv dazu ausgelegt ist, eine Laser-Strukturierung unter Bestrahlung mit einem Laser in einem zweiten Wellenlängenbereich zu ermöglichen, bei der laseraktivierbare Verbindungen in der Kunststoffmischung aktiviert werden, wobei der zweite Wellenlängenbereich von dem ersten Wellenlängenbereich verschieden ist.
ein oder mehrere Leiterstrukturen (20), die auf dem Grundkörper angeordnet sind, wobei die ein oder mehreren Leiterstrukturen durch Laseraktivieren eines Teils einer Oberfläche des Grundkörpers mittels des Lasers und Metallisieren des laseraktivierten Teils der Oberfläche des Grundkörpers hergestellt sind, wobei die Metallisierung die ein oder mehreren Leiterstrukturen bildet.

15. Computerimplementiertes Verfahren zum Generieren von Steuerungsanweisungen für einen Laser, das Verfahren umfassend:
Erhalten (210) eines dreidimensionalen Entwurfsmodells eines stereolithografischen Herstellungsverfahrens; und
Generieren (220) der Steuerungsanweisungen für den Laser basierend auf dem dreidimensionalen Entwurfsmodell des stereolithografischen Herstellungsverfahrens, wobei die Steuerungsanweisungen dazu ausgelegt sind, eine Oberfläche eines Grundkörpers, der durch das dreidimensionale Entwurfsmodell definiert ist, durch eine Bestrahlung durch den Laser selektiv zu aktivieren.

16. Kunststoffmischung zur Verwendung in einem stereolithografischen Herstellungsverfahren, die Kunststoffmischung umfassend:
ein Photopolymer, wobei das Photopolymer dazu ausgelegt ist, unter Bestrahlung mit Licht in einem ersten Wellenlängenbereich zu härten; und
ein Additiv, wobei das Additiv dazu ausgelegt ist, eine Laser-Strukturierung unter Bestrahlung mit einem Laser in einem zweiten Wellenlängenbereich zu ermöglichen, bei der laseraktivierbare Verbindungen in der Kunststoffmischung aktiviert werden, wobei der zweite Wellenlängenbereich von dem ersten Wellenlängenbereich verschieden ist.

17. Nutzen der Kunststoffmischung von Anspruch 16 in einem stereolithografischen Herstellungsverfahren.
